Europäisches Patentamt

European Patent Office

Office européen des brevets

(19)

(11) **EP 1 318 431 A1**

(12) ## EUROPEAN PATENT APPLICATION

(43) Date of publication:
**11.06.2003 Bulletin 2003/24**

(51) Int Cl.⁷: **G03F 7/20**

(21) Application number: **02258293.6**

(22) Date of filing: **02.12.2002**

| | |
|---|---|
| (84) Designated Contracting States:<br>**AT BE BG CH CY CZ DE DK EE ES FI FR GB GR**<br>**IE IT LI LU MC NL PT SE SI SK TR**<br>Designated Extension States:<br>**AL LT LV MK RO** | (72) Inventor: **Box, Wilhelmus Josephus**<br>**2941 Eksel (BE)** |
| (30) Priority: **04.12.2001 EP 01310155** | (74) Representative: **Leeming, John Gerard**<br>**J.A. Kemp & Co.,**<br>**14 South Square,**<br>**Gray's Inn**<br>**London WC1R 5JJ (GB)** |
| (71) Applicant: **ASML Netherlands B.V.**<br>**5503 LA Veldhoven (NL)** | |

(54) **Lithographic apparatus, device manufacturing method, and method of manufacturing an optical element**

(57)     An optical element in a lithographic apparatus is manufactured using a low-CTE material that has a CTE zero-crossing at a temperature between the temperature at which the element is manufactured and the mean temperature at which it will be operated.

Fig. 2

EP 1 318 431 A1

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In order to image ever smaller features, it has been proposed to use EUV radiation, with a wavelength in the range of from 5 to 20 nm, as the exposure radiation instead of UV, with a wavelength of 193 or 157 nm, as is used in current commercial lithography devices. No material capable of forming a refractive lens for optical elements in radiation and/or projections systems for EUV radiation is known so that the radiation and projection systems of an EUV lithographic apparatus must be made using mirrors, usually multilayer mirrors. The quality of the projected image is extremely sensitive to surface deformations (figure errors) in the mirrors, particularly those of the projection system. In order to prevent surface deformations caused by temperature variations, the mirrors are formed by depositing the multilayer stack on a substrate having the desired figure and made of a material having an extremely low, or zero, coefficient of thermal expansion (CTE). Various such materials are commercially available from a variety of suppliers. One, Zerodur™, is a glass ceramic made with various additives to provide the desired low CTE. Whilst these materials have a very low CTE, the CTE is exactly zero at only one temperature so that some thermal expansion and contraction does take place, leading to surface deformations and a loss of image quality.

It is an object of the present invention to provide a lithographic projection system in which thermal effects of optical elements in the radiation and/or projection systems on imaging quality are further reduced or eliminated.

This and other objects are achieved according to the invention in a lithographic apparatus as specified in the opening paragraph, characterized in that at least one component in said apparatus that in use experiences a heat load is made of a low-CTE material having a coefficient of thermal expansion having a zero-crossing at a temperature between the manufacturing temperature and the mean operating temperature of that component.

By constructing the component using a material having a CTE zero-crossing temperature between the manufacturing and mean operating temperatures of the component, the thermal deformation of the component when operating is minimized or eliminated. Because the CTE will, in general, be negative below the zero-crossing temperature and positive above, as the temperature of the component changes from its manufacturing temperature to its operating temperature, the component will deform initially but those deformations will be reversed the other side of the zero-crossing temperature.

The ideal temperature of the zero-crossing will depend on the shape of the CTE as a function of temperature in the region of the zero-crossing. If the CTE is linearly dependent on temperature in that region, a material should be used which has a CTE zero-crossing exactly midway between the manufacturing and mean operating temperatures. In general, the manufacturing, zero-crossing and mean operating temperatures should be such that the integral of the temperature dependent CTE between the manufacturing and mean operating temperatures is zero, or as close thereto as possible.

Where the material used is a glass, or a glass ceramic such as Zerodur™, the CTE zero-crossing temperature can be selected as desired by appropriate control of the additives and/or the manufacturing process.

If necessary, a batch of glass (or glass ceramic) of the desired CTE zero-crossing temperature can be manufactured by trial and error. It will be appreciated that whilst the mean operating temperature of the apparatus might be determined by other considerations, the manufacturing temperature may be adjusted to enable use of a particular glass (or glass ceramic) having a CTE zero-crossing temperature that is fixed or only of limited variability.

The invention may be applied to any component in a lithographic apparatus but is particularly advantageous when applied to optical elements in the path of the projection beam, especially mirrors in an EUV lithographic apparatus, especially those of the projection system, where surface deformations have the greatest effect on imaging quality, and those in the beginning of the illumination system, where the projection beam intensity is highest, leading to larger temperature variations. The invention is also particularly applicable to small mirrors where the thermal load is concentrated, again leading to larger temperature variations. It will be appreciated that for multilayer mirrors, only the substrate, and not the multilayer stack, will be made out of the low-CTE material.

It is generally preferably for consistency reasons to make all of the optical elements affecting the projection beam in a lithography apparatus from the same batch of material so that if the operating temperatures of the different optical elements differ, the zero-crossing temperature may only be ideal for one element. In that case, the zero-crossing temperature is preferably chosen to be ideal for the mirror having the highest heat load, generally the first mirror.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,

characterized in that at least one component in said apparatus experiencing a heat load has a mean operating temperature and is made of a low-CTE material such that the CTE zero-crossing temperature of said low-CTE material is between the manufacturing temperature of said component and said mean operating temperature.

According to a still further aspect of the present invention there is provided a method of manufacturing an optical element that will, in use, experience a heat load and will be operated at a mean operating temperature, the method comprising the steps of:

selecting a low-CTE material having a zero coefficient of thermal expansion at a first temperature; manufacturing at least said optical element using said selected low-CTE material at a second temperature; characterized in that:

said first temperature is between said second temperature and said mean operating temperature so as to minimize surface deformation of said optical element, at said operating temperature.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 is a graph illustrating the temperature dependence of the coefficient of thermal expansion (CTE) of a glass (or glass ceramic) used in the present invention; and
Figure 3 is a graph illustrating the temperature dependence of the surface deformation of an optical element according to the invention.

In the Figures, corresponding reference symbols indicate corresponding parts.

Embodiment 1

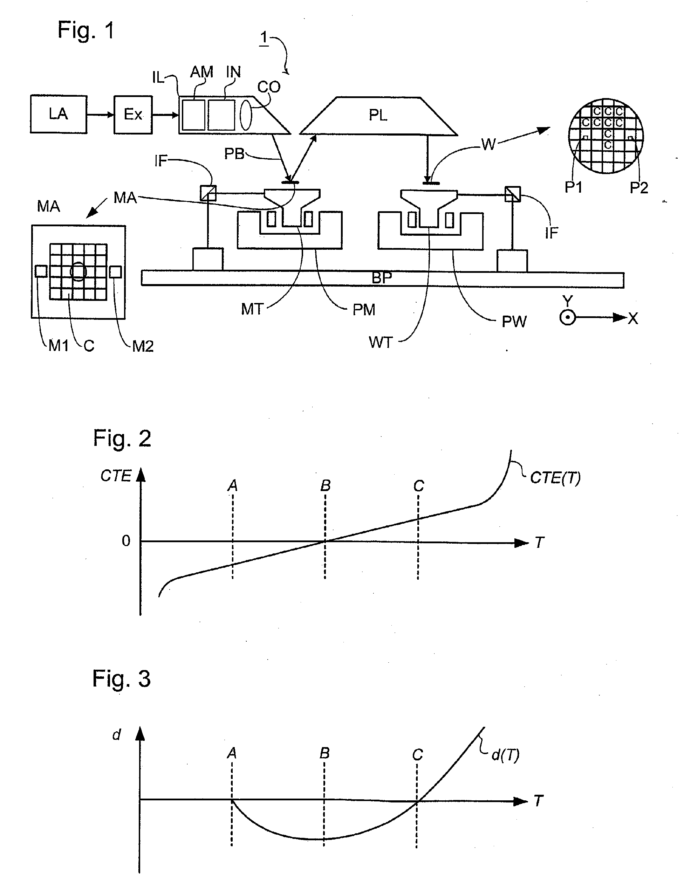

Figure 1 schematically depicts a lithographic projection apparatus according to a particular embodiment of the invention. The apparatus comprises:

· a radiation system Ex, IL, for supplying a projection beam PB of radiation *(e.g.* EUV radiation), which in this particular case also comprises a radiation source LA;
· a first object table (mask table) MT provided with a mask holder for holding a mask MA (*e.g.* a reticle), and connected to first positioning means PM for accurately positioning the mask with respect to item PL;
· a second object table (substrate table) WT provided with a substrate holder for holding a substrate W (*e.g.* a resist-coated silicon wafer), and connected to second positioning means PW for accurately positioning the substrate with respect to item PL;
· a projection system ("lens") PL (*e.g.* a group of multilayer mirrors) for imaging an irradiated portion of the mask MA onto a target portion C (*e.g.* comprising one or more dies) of the substrate W.

As here depicted, the apparatus is of a reflective type (*i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed ν, so that the projection beam PB is caused to scan over a mask image; concurrently, the substrate table WT is simultaneously moved in the same or opposite direction at a speed $V = M\nu$, in which $M$ is the magnification of the lens PL (typically, $M = 1/4$ or 1/5). In this manner, a relatively large target portion C can be exposed, without having to compromise on resolution.

Figure 2 illustrates the temperature dependence of the coefficient of thermal expansion of a low-CTE glass ceramic, such as Zerodur™, or glass, such as ULE™, which may be used to make the substrates of multilayer mirrors in the illumination and projection systems of the lithographic apparatus 1. It can be seen that the curve $CTE(T)$, the coefficient of thermal expansion as a function of temperature $T$, crosses zero at a temperature $B$ and is substantially linear for a range of temperatures either side of $B$. According to the invention, the optical element is manufactured at a temperature $A$ and operated at a mean temperature $C$ such that $A$ and $C$ are within the range of temperatures for which $CTE(T)$ is substantially linear and $B$ is between A and C so that:

$$A \le B \le C \qquad \text{or} \qquad A \ge B \ge C \qquad (1)$$

Preferably, the zero-crossing temperature $B$ is midway between the manufacturing temperature $A$ and the mean operating temperature $C$ so that:

$$B = \frac{A + C}{2} \qquad (2)$$

In the more general case, where $CTE(T)$ is not linear in the range from $A$ to $C$, the glass (or glass ceramic), manufacturing temperature and/or mean operating temperature should be selected such that:

$$\int_A^C CTE(T)dT = 0 \qquad (3)$$

If the above criteria are satisfied, the surface deformation of the mirror at the mean operating temperature will be substantially zero. This can be seen from Figure 3, which illustrates surface deformation $d$ as a function of temperature, $T$. In this example where $A$ is less than $C$ and $CTE(T)$ is negative below $B$, the initial contraction of the mirror as its temperature rises from $A$ to $B$ is reversed as the temperature continues to rise above $B$.

As an example, the manufacturing temperature might be 22°C and the mean operating temperature about 30°C, so that a glass (or glass ceramic) with a CTE zero-crossing of 26°C would be chosen.

The skilled reader will know that high-precision optical elements such as are used in lithography apparatus are normally ground to their final configuration whilst being maintained at a very constant temperature. However, in the event that manufacturing steps occur at different temperatures it is the temperature of the final polishing and figure checking step that is relevant as the manufacturing temperature for the purposes of the present invention.

Whilst specific embodiments of the invention have been described above, it will be appreciated that the invention may be practiced otherwise than as described. The description is not intended to limit the invention.

**Claims**

1. A lithographic projection apparatus comprising:

   - a radiation system for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate;

   **characterized in that** at least one component in said apparatus that in use experiences a heat load is made of a low-CTE material having a coefficient of thermal expansion having a zero-crossing at a temperature between the manufacturing temperature and the mean operating temperature of that component.

2. Apparatus according to claim 1 wherein the temperature of said zero-crossing is substantially equal to the average of said manufacturing temperature and said mean operating temperature.

3. Apparatus according to claim 1 or 2 wherein the integral of the coefficient of thermal expansion of said low-CTE material from said manufacturing temperature to said operating temperature is substantially zero.

4. Apparatus according to claim 1, 2 or 3 wherein said at least one component is an optical element in said radiation and/or projection systems.

5. Apparatus according to claim 4 wherein said optical element is the optical element in said radiation and/or projection system that experiences in use the highest thermal load.

6. Apparatus according to claim 4 or 5 wherein said optical element is a mirror.

7. Apparatus according to claim 6 wherein said mirror comprises a substrate manufactured from said low-CTE material and a multilayer stack.

8. A device manufacturing method comprising the steps of:

   - providing a substrate that is at least partially covered by a layer of radiation-sensitive material;
   - providing a projection beam of radiation using a radiation system;
   - using patterning means to endow the projection beam with a pattern in its cross-section;
   - projecting the patterned beam of radiation onto a target portion of the layer of radiation-sensitive material,

   **characterized in that** at least one component in said apparatus experiencing a heat load has a mean operating temperature and is made of a low-CTE material such that the CTE zero-crossing temperature of said low-CTE material is between the manufacturing temperature of said component and said mean operating temperature.

9. A method of manufacturing an optical element that will, in use, experience a heat load and will be operated at a mean operating temperature, the method comprising the steps of:

   selecting a low-CTE material having a zero coefficient of thermal expansion at a first temperature;
   manufacturing at least said optical element using said selected low-CTE material at a second temperature; **characterized in that**

said first temperature is between said second temperature and said mean operating temperature so as to minimize surface deformation of said optical element at said operating temperature.

**Fig. 1**

**Fig. 2**

**Fig. 3**

European Patent
Office

**EUROPEAN SEARCH REPORT**

Application Number

EP 02 25 8293

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 265 143 A (EARLY KATHLEEN R ET AL) 23 November 1993 (1993-11-23) * column 1, line 7 - line 9 * * column 1, line 48 - line 51 * * column 4, line 56 - column 5, line 2 * * column 5, line 50 - column 6, line 39 * | 1,4,6-9 | G03F7/20 |
| A | US 6 159 643 A (LEVINSON HARRY ET AL) 12 December 2000 (2000-12-12) * column 1, line 6 - line 7 * * column 2, line 14 - line 27 * * column 4, line 7 - line 34 * * figure 3 * | 1,4,6-9 | |
| A | "Optics Guide 3" 1985 , MELLES GRIOT , IRVINE, CA, USA XP002198547 * page 177 * * page 68 * | 1,8,9 | |
| A | US 5 303 588 A (HAMISCH HANSJOACHIM ET AL) 19 April 1994 (1994-04-19) * column 3, line 47 - line 54 * | 1,8,9 | TECHNICAL FIELDS SEARCHED (Int.Cl.7) G03F |
| A | US 4 924 701 A (DELATORRE LEROY C) 15 May 1990 (1990-05-15) * column 16, line 47 - line 60 * | 1,8,9 | |

The present search report has been drawn up for all claims

| Place of search | Date of completion of the search | Examiner |
|---|---|---|
| THE HAGUE | 10 March 2003 | Aguilar, M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**          EP 02 25 8293

This annex lists the patent family members relating to the patent documents cited in the above-mentioned European search report.
The members are as contained in the European Patent Office EDP file on
The European Patent Office is in no way liable for these particulars which are merely given for the purpose of information.

10-03-2003

| Patent document cited in search report | | Publication date | Patent family member(s) | | Publication date |
|---|---|---|---|---|---|
| US 5265143 | A | 23-11-1993 | DE | 69318279 D1 | 04-06-1998 |
| | | | DE | 69318279 T2 | 27-08-1998 |
| | | | EP | 0605966 A1 | 13-07-1994 |
| | | | EP | 0769787 A1 | 23-04-1997 |
| | | | JP | 2918781 B2 | 12-07-1999 |
| | | | JP | 6273604 A | 30-09-1994 |
| US 6159643 | A | 12-12-2000 | NONE | | |
| US 5303588 | A | 19-04-1994 | DE | 3917832 A1 | 13-12-1990 |
| | | | WO | 9015335 A1 | 13-12-1990 |
| | | | DE | 59000433 D1 | 10-12-1992 |
| | | | EP | 0426814 A1 | 15-05-1991 |
| | | | JP | 2818291 B2 | 30-10-1998 |
| | | | JP | 4500273 T | 16-01-1992 |
| US 4924701 | A | 15-05-1990 | NONE | | |